# EUROPEAN PATENT APPLICATION

(11) **EP 4 271 145 A1**
(43) Date of publication of application: **01.11.2023**
(21) Application number: 22170554.4
(22) Date of filing: 28.04.2022
(51) Int. Cl.: H05K 3/00, H05K 3/28

(54) **MANUFACTURING A COMPONENT CARRIER USING A PROTECTION LAYER**

(71) Applicant: AT & S Austria Technologie & Systemtechnik Aktiengesellschaft, 8700 Leoben (AT)
(72) Inventor: Reitmaier, Bernhard, 8763 Pölstal/Möderbrugg (AT); Trischler, Heinrich, 8793 Trofaiach (AT); Weidinger, Gerald, 8700 Leoben (AT); Brosch, Michaela, 8720 Knittelfeld (AT); Zipper, Wolfgang, 8330 Feldbach (AT)
(74) Representative: Dilg, Haeusler, Schindelmann Patentanwaltsgesellschaft mbH

(57) **Abstract**

It is described a method of manufacturing a component carrier, the method comprising:
i) providing a component carrier (100) with at least one electrically insulating layer structure and/or at least one electrically conductive layer structure;
ii) forming a protection layer (150) on the component carrier (100), so that a first portion (130) of the surface of the component carrier (100) is covered with the protection layer (150), and a second portion (140) of the surface of the component carrier (100) is not covered with the protection layer (150);
iii) performing a component carrier manufacture step with respect to the second portion (140); and afterwards
iv) removing the protection layer (150) from the first portion (130) using a pressurized fluid.

## Description

### Field of the Invention

The invention relates to a method of manufacturing a component carrier, in particular including a formation of a protection layer on specific portions of the component carrier a removal of said protection layer using a fluid. Further, the invention relates to a specific use of a pressurized fluid jet.

Accordingly, the invention may relate to the technical field of manufacturing component carriers such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, selectively processing only a part of the component carrier during manufacture (e.g. by etching, plating, bonding, etc.) may be considered a challenge. Conventionally, special varnishes may be used for partially covering a portion that should not be processed during manufacture. However, these materials are often expensive and only suitable for very specific applications. Further, it may be challenging to remove these varnishes without causing harm to the component carrier surface under manufacture.

Generally, such varnishes are manually removed, e.g. using e.g. tweezers. However, manual removal is expensive and work-intensive and not suitable for mass production. Another option would be to remove the varnish using aggressive chemicals (e.g. acids or alkalines). Nevertheless, chemical removal may harm the component carrier surface. Even if these varnishes would be removed without harming the surface, residues may remain on the surface and may cause disturbance to electronic connections. Especially in case of high frequency signals (e.g. in the Gigahertz range), quality of electric traces and connections may be crucial.

### Summary of the Invention

There may be a need to selectively process only a portion of a component carrier surface during manufacture in an efficient and reliable manner.

A method and a use are provided.

According to an aspect of the invention, there is described a method of manufacturing a component carrier, the method comprising:
i) providing a component carrier (in particular a preform of a component carrier, e.g. a panel) with at least one electrically insulating layer structure and/or at least one electrically conductive layer structure;
ii) forming a protection layer (for example a strip varnish) on the component carrier, so that a first portion (portion to be protected) of the (main, i.e. along the direction of main extension) surface of the component carrier is covered with the protection layer, and a second portion (portion to be processed) of the (main) surface of the component carrier is not covered with the protection layer; iii) performing a component carrier manufacture step with respect to the second portion (processing the portion to be processed); and afterwards iv) removing (in particular in a residue-free manner) the protection layer (at least partially) from the first portion using a pressurized fluid (e.g. a water jet).

According to a further aspect of the invention, there is described a component carrier manufacture apparatus, comprising a protection layer removal device that comprises at least one, in particular a plurality of, high pressure nozzles (more in particular in form of a nozzle array), that are configured to provide a plurality of pressurized fluid jets, respectively. The protection layer removal device is configured to remove a protection layer, using the plurality of pressurized fluid jets, from a first portion of surface of a component carrier, wherein the first portion of the surface of the component carrier is covered with the protection layer, and a second portion of the surface of the component carrier is not covered with the protection layer.

According to a further aspect of the invention, there is described a use (method of using) a hot high-pressure (pressurized) fluid jet to remove a protection layer from (at least) a portion of a surface of a component carrier in a residue-free manner.

In the context of the present document, the term "protection layer" may refer to any layer structure that may be suitable to cover at least a part (portion) of a component carrier surface. By covering said surface portion, it may be protected from component carrier manufacture processes such as etching, plating, surface roughening, etc. For example, a protection layer may comprise one of an elastic polymer coating, an ink, a bond film, a peel-off film, a strip varnish. Preferably, the protection layer is chemically inert, e.g. against acids and alkaline substances (e.g. alkaline cleaner). Further, the protection layer may be heat-resistant, in particular resistant against soldering temperatures. As a consequence, it may not be possible to remove the protection layer in an efficient and reliable manner using chemicals and/or heat (in particular not in a short period of time, such as less than two minutes). The protection layer should be provided in a selective manner only on first portions(s) to be protected. This may be done using a mask, e.g. by screen printing. The term "protection layer" may refer to a continuous layer or to a plurality of (separate) islands in a common plane. For example, the protection layer may be configured as a plurality of strip varnishes or films that are distributed over the component carrier surface, thereby covering a plurality of first portions.

In the context of the present document, the term "pressurized fluid" may in particular refer to a fluid that is provided with a pressure that is higher than 1 bar, in particular 2 bar or more. The physical state of the fluid may be one of liquid (e.g. water), gaseous (e.g. steam), or supercritical. Organic and/or inorganic substances and/or dispersed solids (e.g. surfactants) may be present in the fluid. Preferably, the fluid is free of additional chemicals. In an example, the pressurized fluid is provided as a fluid jet, for example by a high pressure cleaning machine. The later may comprise a pressure washer nozzle, so that the properties of the jet can be adjusted. In an example, multiple pressure washer nozzles may be applied above and below the panel in several spray bars having specific angles, for example an 45° angle in X-Y direction with respect to the X-Y panel orientation and/or transportation rollers in the middle of the module).

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

According to an exemplary embodiment, the invention may be based on the idea that only a first portion of a component carrier surface can be selectively provided as desired during manufacture in an efficient and reliable manner, when said first portion is covered during processing of a second (un-protected) portion by a protection layer, and when the protection layer is removed, in particular residue-free, afterwards by using a pressurized fluid. Especially advantageous for a residue-free removal may be protection layers, that are inert against chemicals and/or heat resistance. However, as a consequence, it may be a challenge to efficiently remove these protection layers as they will not chemically react or decompose under heat. Conventionally, such protection layers have been removed manually in a tedious manner or their use may have been simple avoided.

It has now been surprisingly found by the inventors that the described protection layer may be removed in an especially efficient and reliable manner (without leaving residues), when a pressurized fluid, for example a water jet, is applied against the protection layer. The pressurized fluid may hereby not decompose or destroy (at least the micro-structure of) the protection layer, as would be expected, but pulls instead the protection layer off the component carrier surface. Since no additional chemicals are necessary, also the component carrier surface is protected and no environmentally harmful substances have to be discarded afterwards.

In a basic example, a high pressure cleaning machine, such as a Kärcher^{®}, may be directly applied on the component carrier surface (preferably in an angle close to 45°) to thereby peel off the protection layer. The described, surprisingly easy and straightforward, method may be directly implemented in existing production lines and enables the application of (inert) protection layers for a plurality of manufacture processes.

### Description of Exemplary Embodiments

According to an embodiment, the physical state of the fluid is at least one of liquid, gaseous, supercritical. While in one example a liquid like water is applied, it has turned out that also the application of a gas stream may efficiently peel off the protection layer.

According to a further embodiment, the fluid comprises organic and/or inorganic substances and/or dispersed solids. In an example, the fluid is free of additional chemical substances. Thus, a fluid like water can be directly applied without work-intensive purification processes. Water may contain further substances and dispersed solids, but it has turned out that (intensive) purification processes may not be necessary. Preferably, the fluid in liquid state may be degassed to prevent oxidation and/or corrosion reactions in the surface of a metallic layer.

Further, mixture of pure substances may be used (e.g. a mixture of 95% water and 5% ethanol). In an example, the fluid comprises an organic substance and/or an inorganic substance and or a mixture thereof. Alternatively, the fluid may comprise a plurality of organic substances and/or a plurality of inorganic substances and/or a mixture thereof. In a further example, the fluid comprises a dispersed solid.

According to a further embodiment, the removing is done without using an organic solvent (organic solvent free). According to a further embodiment, removing is (essentially) free of using additional chemical substances. This may provide the advantage that no chemicals are used that may react with the component carrier surface. Hence, a high quality component carrier surface may be obtained, which can be crucial for high frequency applications.

According to a further embodiment, the pressure of the pressurized fluid is 2 bar or more, in particular 3 bar or more, more in particular 5 bar or more, more in particular 10 bar or more. In a basic example, the term "pressurized" may refer to a pressure being higher than 1 bar. It has turned out that already pressures such as 2 bar or 3 bar may be sufficient for efficiently removing the protection layer. Such pressures may be easily provided by a high pressure nozzle/cleaner. In an example, the pressure may not be set too high in order to avoid damage to the component carrier surface.

According to a further embodiment, removing comprises at least one of an ultrasonic treatment, a hot water (bath), an air knife with hot pressurized air, in particular above 5 bar. Such additional measures may further support removing by the pressurized fluid. The hot pressurized air may also be used as the pressurized fluid without additional measures.

According to a further embodiment, the temperature of the pressurized fluid is 25°C or more, in particular 40°C or more, in particular 60°C or more. In other words, the pressurized fluid is hot. An elevated temperature may provide the advantage that removing the protection layer is even more efficient. In an example, the temperature may not be set too high in order to avoid damage to the component carrier surface. The protection layer may nevertheless be stable against such temperatures.

According to a further embodiment, the pressurized fluid is applied as a jet, in particular wherein the jet is provided by a high-pressure cleaner and/or a fluid nozzle. This may provide the advantage that existing and established technology can be directly applied to provide the (hot) pressurized fluid as a jet. In this context, the term "jet" may refer to a fluid that is provided with a specific direction.

According to a further embodiment, during the removing, an angle (α) in the vertical (z) direction between an imaginary plane, being parallel to the component carrier surface, and the fluid jet direction is in the range 40° (or 30°) to 80°, in particular 50° to 70°, more in particular 55° to 65°, more in particular essentially 60°.

According to a further embodiment, during removing, an angle (β) in the horizontal (x, y) direction between a further imaginary plane, being perpendicular to the component carrier surface/imaginary plane, and the fluid jet direction is in the range 30° to 70°, in particular in the range 40° to 50°, more in particular around 45°.

According to a further embodiment, at least two fluid jets are applied. Hereby the direction may eb the same or different. In an example the directions are mirror images of each other.

In an example, the fluid jet is applied in the first place in the X-Y (horizontal) direction to ensure the protection layer (e.g. peel-off ink) is removed (peeled, lifted) at the corners first. Furthermore, the fluid jet should be hitting the panel around 30°-80°, preferred around 60° in the vertical (z) direction to ensure an efficient lifting of the protection layer.

In an example, to compensate the fluid pressure from the fluid jet on a component carrier preform (e.g. single panel) side and to avoid bending of thin component carrier preforms during the removing (peel-off) process, the fluid jet process may be done in a mirrored alignment of fluid jet nozzles on the top and bottom of the component carrier preform, e.g. positioned in a 45° angle to the transportation rollers in between and the panel.

It has been turned out that the described angles may be enable an especially efficient peel off removal of the protection layer. The term "fluid jet direction" may in this context refer to an imaginary line parallel to the applied fluid jet. In case that a nozzle and/or a cleaning machine is applied, the orientation of the nozzle/cleaning machine may define the direction of the fluid jet.

In an exemplary embodiment, at least some of the nozzles are configured as rotating nozzles.

In an example, the fluid jet may also be applied from a plurality of directions (from upwards, from downwards). For example, the pressurized fluid jet is directed against the forward moving direction of the component carrier inside a manufacture apparatus. Additionally and/or alternatively, the pressurized fluid jet is directed in same direction as the forward direction inside the apparatus.

In an example, if the component carrier (preform) is fastened to a support frame, the fluid jet may be applied from the bottom with an upwardly oriented direction. Mounting (associating) the (semi-finished) component carrier on/to a support frame may be done during production.

In an example, spray bars (e.g. oriented in 45° in X-Y direction) and equipped with several rotating nozzles may be used to remove the protection layer with hot fluid and pressure.

According to a further embodiment, the manufacture apparatus, in which the removal is performed, comprises at least one of a loader, a pre-heater, a protection layer removal unit, a fluid/water purification, a component carrier cleaning unit, a dryer, an unloader. This may provide the advantage that the described method may be directly implemented efficiently into existing production lines. Manufacture along production lines may be especially efficient, when the removal can be done in short time (e.g. lower than two minutes, in particular lower than one minute). According to a further embodiment, at least the micro-structure of the protection layer is (essentially) not decomposed by the fluid. For example, the protection layer may be released in patches. Thus, the protection layer may not be decomposed or destroyed by the (hot) pressurized fluid. In an example, it has been surprisingly found that the (hot) pressurized fluid does not decompose the protection layer at a micro-structure level. Instead, the protection layer is released as a whole or in patches. In this manner, the component carrier surface may be left behind residue-free and unharmed. In other words, the protection layer, e.g. peel-off ink, is not supposed to break into pieces but should be peeled-off in one large piece. Nevertheless, in another embodiment, the protection layer may break down into pieces (at the macro-structure level).

According to a further embodiment, the protection layer (e.g. ink) patches and particles after removing (peel-off process) may be collected. For example at least one filter unit may be used, e.g. connected to a water jet module. Any suitable filter unit can be used, preferred is e.g. a rotating drum filter unit included next to the water jet module. The suspension of (hot, pressurized) fluid (e.g. water) and protection layer patches is flowing (e.g. into the filter such as the rotating drum filter unit) and the particles are collected (e.g. on the bottom in front of the filter unit in a suitable collection container such as a box).

According to a further embodiment, the protection layer is chemically inert, in particular stable against acidic and alkaline substances. This may provide the advantage that a plurality of chemical processes (e.g. etching, plating, sintering, etc.) can be performed with respect to the second portion without interacting with the protection layer. Thereby, an especially efficient component carrier manufacture may be enabled.

According to a further embodiment, the protection layer is heat-resistant, in particular resistant against soldering temperatures. This may provide the advantage that a plurality of heat-involving processes (e.g. soldering, laminating, etc.) can be performed with respect to the second portion without affecting the protection layer. Thereby, an especially efficient component carrier manufacture may be enabled.

According to a further embodiment, the protection layer comprises at least one of the group which consists of an elastic polymer coating, an ink, an adhesion promoter (e.g. a bond film), a peel-off film, a strip varnish. In an example, the protection layer may be epoxy-based, acryl-based and/or latex-based. Also a mixture of these or other materials may be possible. Thus, commercially available and/or established materials may be directly applied in a straightforward manner.

According to a further embodiment, the protection layer comprise an elastic material, in particular wherein the Young's modulus of the (elastic material of the) protection layer is range 0.005 GPa to 0.5 GPa, more in particular in the range 0.01 GPa to 0.1 GPa, more in particular in the range 0.025 GPa to 0.075 GPa. Thereby, protection properties as well as removal properties may especially advantageous.

According to a further embodiment, providing the protection layer comprises: coating, in particular printing, more in particular screen printing, the protection layer on the first portion. Thereby, the protection layer may be efficiently applied in a selective manner. In particular, the protection layer comprises a plurality of (separated) regions, e.g. strip varnishes, so that there may be a need to accurately distribute these over the component carrier surface.

According to a further embodiment, the method further comprising: providing a solder resist to the component carrier prior to providing the protection layer. A solder resist (layer structure) (at least partially) at the first portion may be efficiently protected by the protection layer.

According to a further embodiment, the component carrier manufacture step of the second portion comprises at least one of the group which consists of: roughening (in particular by micro-etching), etching (in particular physical/chemical etching), addition of a layer structure, plating, differential etching, bonding, adhesion, oxidation (in particular black oxide treatment), precleaning, providing surface preservative, submerging, assembly of a component, provision of a cavity. Thus, a plurality of different component carrier manufacture techniques can be applied, while the first portion (not to be processed) is selectively protected. Depending on the properties of the protection layer, also processes involving aggressive chemicals or high temperatures may not affect the protection layer.

According to an embodiment, at least one metal trace comprises a shape from the group which consists of: rectangular, trapezoidal, frustoconical, cuboidal, cylindrical.

According to an embodiment, surface roughening may be widely used in the component carrier industry to improve the adhesion between metal (e.g. copper) and the dielectric material (such as FR4 or solder resist) due to the higher roughness. A high roughness on the metal may lead to better adhesion of the dielectric material, but may have the disadvantage that the high roughness, due to the skin effect, leads to signal losses in the high-frequency range. Furthermore, less rough (oxide-free) metallic surfaces may be required for sintering processes. Conventionally, high roughness surfaces may be produced in an expensive and time-consuming laser ablation process, whereby the metallic surface is roughened and therefore no longer suitable for high-frequency applications. Nevertheless, using the method described above, metal surfaces with a high roughness and a low roughness may be produced in an efficient and reliable manner, in particular by including a micro-etching process for surface roughening second portion metal surfaces, while first portion metal surfaces are protected by the protection layer and are thus not affected by the micro-etching.

According to a further embodiment, the first portion and/or the second portion of the component carrier surface comprise a metal layer structure (in particular a metal trace), and the method further comprises:
i) forming a first metal trace with a smooth surface at the first portion, and/or
ii) forming a second metal trace with a rough surface at the second portion.
As described above, a surface roughening process (e.g. micro-etching) may be applied selectively only to the second portion.

According to a further embodiment, a metal trace comprises rough surface portions and smooth surface portions, in particular in an alternating manner. In this example, a metal trace may belong partially to the first portion and partially to the second portion, so that only a part of the metal surface is roughened.

In an example, traces which have a higher fraction (e.g. > 50%) of rough surface area may be preferably used for power supply. Alternatively, traces which have lower fraction (e.g. < 50%) of rough surface area may be preferably used for signal transport (e.g. high frequency, high speed).

According to a further embodiment, the rough surface comprises a surface roughness of more than 500 nm, in particular more than 700 nm.
According to a further embodiment, the smooth surface comprises a surface roughness of less than 500 nm, in particular less than 300 nm, more in particular less than 100 nm. Thereby, high requirements for signal transmission may be fulfilled in an accurate manner.

According to an embodiment, between the protection layer and the first portion (e.g. metallic surface), there may be an inclusion of a fluid, e.g. gas/air. Nevertheless, an (essentially) inclusion-free embodiment may be preferred. Further embodiment:

According to an embodiment, the (uncovered) second portion of the metal trace may be further smoothed by applying energy, e.g. in form of a laser and or by applying suitable electrochemical processes. In the latter, copper or other metals (Ni, Au, Sn) may be plated on the surface.

According to an embodiment, only the bottom/top surfaces of at least one metal trace are covered, so that selectively roughened side walls are formed. According to an embodiment, only the sidewall surfaces of at least one metal trace are covered, so that selectively roughened side walls are formed.

According to an embodiment, rough surfaces may improve the performance of treatment of electromagnetic waves (e.g. generated by a laser).

According to an embodiment, rough surface areas may be formed, where components including their connection pads are applied, thereby eventually creating higher reliable connection(s).

According to an embodiment, selected areas, where delamination may more frequently occur (in particular at the component carrier edges), could be roughened to prevent delamination.

According to an embodiment, in particular when small traces (e.g.< 5µm) are used (in high density areas) further rough surfaces may be provided to prevent delamination. These rough surfaces may be provided by dummy structures (which do not take part in high frequency signal transmission and/or do not take part in the transport of electric current at all). These dummy structures may comprise a larger volume/height/width than first metal traces with smooth surfaces. In an example, a large dummy structure is arranged in the center of a component carrier.

According to an embodiment, after the removal of the protective layer, the first portion of the surface of the component carrier may be (selectively) modified by a further manufacturing process step, e.g. applying a sinter paste.

According to a further aspect of the invention, there is described a component carrier manufacture apparatus, configured to perform the method described above.

According to an embodiment, the component carrier manufacture apparatus comprises at least one of the following features: a loader, an unloader, a preheater, a protection removal chamber, a component carrier cleaner, in particular ultrasonification, a dryer.

According to an embodiment, the apparatus is configured to perform the protection layer removal automatically.

According to an embodiment, the loader and/or the unloader may comprise a robot arm or different machine parts (e.g. a conveyor belt) to perform the local movement of the component carrier (preforms).

According to an embodiment, the preheater may be configured to adjust the temperature of the component carrier (preform) to an elevated temperature (e.g. so a similar temperature as the pressurized fluid) to ensure effective removal of the protection layer. Alternatively, the preheater may heat to a temperature higher or lower than the pressurized fluid temperature.

According to an embodiment, the protection layer removal device may comprise the protection layer separation unit, configured to recycle at least part of the used fluid. Further, protection layer separation unit may be configured to collect and/or recycle at least part of the removed protection layer (patches).

According to an embodiment, the component carrier cleaner may be configured to apply ultrasonic waves in the air and/or in a cleaning bath. The bath may hereby comprise an additive to ensure complete removing of remaining protection layer parts and or remaining fluid on at least one (preferred all) the component carrier (preform) surface(s). In a specific embodiment, the manufacture apparatus functions as follows:
i) the loader device loads a component carrier preform along a forwarding direction into the apparatus.
ii) the preheater device preheats the component carrier preform, in particular to a temperature comparable to the temperature of the pressurized fluid.
iii) in the protection removal chamber, the protection layer is removed by a plurality of pressurized fluid jets respectively provided by fluid nozzles.
iv) the component carrier cleaner cleans (in particular using ultrasonification), the component carrier preform from residues of protection layer and/or fluid.
v) the a dryer removes fluid, in particular liquid.
vi) the unloader unloads the protective layer-free component carrier from the apparatus.

According to an embodiment, the component carrier (preforms) may be attached to a clamping system and may be treated in a vertical manner. Thus, the component carrier (preforms) can be handled in the apparatus (in particular in the forwarding direction) in a vertical or horizontal orientation.

According to an embodiment, the protection removal chamber comprises a separation unit, which separates the pressurized fluid from the protection layer and at least partially recycles the fluid.

According to an embodiment, at least some metal traces are formed using a subtractive and/or an additive process.

According to an embodiment, after removal of the protection layer, first surfaces (e.g. copper) are covered by (an) additional layer(s). According to a further embodiment, the method further comprises: configuring the component carrier, so that high-frequency, HF, signals can be guided through the first metal trace, wherein the HF signals comprise a frequency of at least 1 GHz, in particular at least 6 GHz, in particular at least 28 GHz. As described above, a low surface roughness may reduce the skin effect and thereby provide an increased signal transmission quality. In an example, only the first metal trace(s) is/are applied for said high frequency signal transmissions.

In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, socalled prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

### Brief Description of the Drawings

The aspects defined above and further aspects of the invention are apparent from the examples of embodiment to be described hereinafter and are explained with reference to these examples of embodiment.
Figure 1 shows a component carrier surface partially covered with the protection layer according to an exemplary embodiment of the invention.
Figure 2 shows a step of removing the protection layer from the component carrier surface according to an exemplary embodiment of the invention.
Figure 3 shows the component carrier surface after partially removing the protection layer and Figure 4 shows the component carrier surface after fully removing the protection layer, according to exemplary embodiments of the invention.
Figure 5 shows component carrier metal traces manufactured with the described method according to exemplary embodiments of the invention.
Figure 6 shows steps of removing the protection layer from the component carrier surface according to further exemplary embodiments of the invention.

### Detailed Description of the Drawings

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, the method comprises: selective micro-etching/selective bond film allows to protect selected areas (portions) with peel-off mask (protection layer). The peel-off mask can be peeled off with hot high pressure water gun without damage of bond film structure and chemistry. A use of different sinter pastes and/or single smooth HF tracks can be enabled. Further, selective micro-etching of outer layer before solder mask may make (antenna) areas with < 0,5 µm roughness possible.

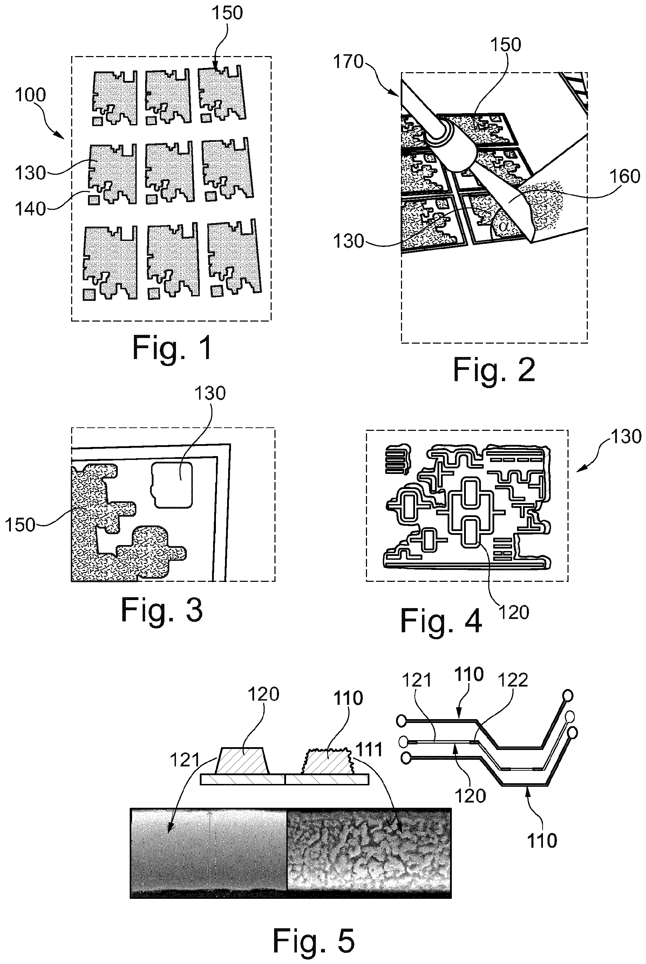

**Figure 1** shows a component carrier 100 surface partially covered with the protection layer 150 according to an exemplary embodiment of the invention. In this example, the component carrier 100 is a component carrier preform that is configured as a panel with a plurality (here nine) of component carriers that are under the manufacturing process. The component carriers are semi-finished products that will all be processed together in the panel and are afterwards separated (diced) into nine single component carrier products. Each of the component carriers 100 comprises a stack (or a preform of a stack) with at least one electrically insulating layer structure and/or at least one electrically conductive layer structure.

The protection layer 150 is formed on the component carrier 100, so that a first portion 130 (dark colour) of the surface of the component carrier 100 is covered with the protection layer 150, and a second portion 140 of the surface of the component carrier 100 is not covered with the protection layer 150. In this manner, a manufacture step can be performed with respect to the second portion 140, wherein said manufacture step does not affect the first portion 130. The manufacture step can comprise for example an etching process, in particular surface roughening by micro-etching.

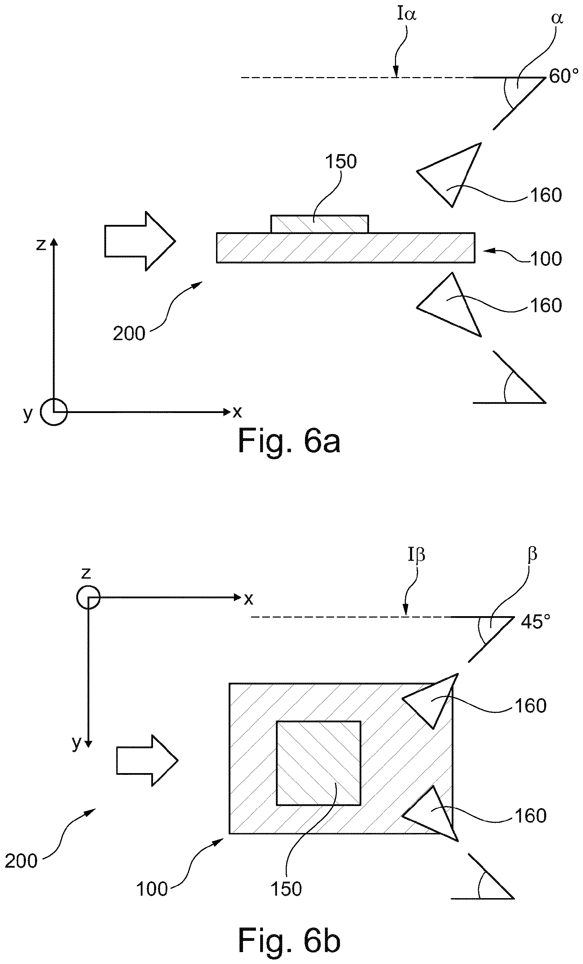

**Figure 2** shows a step of removing the protection layer 150 from the component carrier 100 surface according to an exemplary embodiment of the invention. Removing of the protection layer 150 from the first portion 130 is done after the second portion 140 has been processed. A hot pressurized fluid jet 160 is provided using a nozzle of a high-pressure cleaner (e.g. a Kärcher^{®} machine) 170. In an example, the fluid comprises water, so that the removing is done without using an organic solvent and without using additional chemical substances. The pressure of the pressurized fluid is in this example 3 bar and the hot temperature is 60°C. An angle α in the vertical (z) direction between the component carrier 100 surface and the fluid jet 160 direction is in this example 40°. A corresponding angle between an imaginary plane (see Figure 6a) parallel to the component carrier surface and the fluid jet 160 direction would then be 60°. It can be seen that the protection layer 150 is not decomposed by the fluid but is instead peeled-off.

The protection layer 150 is chemically inert and stable against acidic and alkaline substances. Further, the protection layer 150 is heat-resistant, e.g. against soldering temperatures. For example, the protection layer 150 comprise an elastic polymer coating (e.g. rubber ink, latex polymer(s)).

**Figure 3** shows the component carrier 100 surface after partially removing the protection layer 150 according to an exemplary embodiment of the invention. While further first portions are still covered with the protection layer 150, another first portion 130 is exposed after removing the protection layer 150. For example, the surfaces of second portion metal traces have been roughed, while the surface of first portion metal traces have been protected. As a consequence, the surface of first portion metal traces are still smooth.

**Figure 4** shows the component carrier 100 surface after fully removing the protection layer 150, according to an exemplary embodiment of the invention. A plurality of exposed metal traces can be seen on the component carrier 100 surface. In this example, the surface of the first portion metal traces has not been roughened. Further, copper sinter paste has been printed on some areas that have been protected with the protection layer.

**Figure 5** shows component carrier 100 metal traces 110, 120 manufactured with the described method according to exemplary embodiments of the invention. A first metal trace 120 comprises a smooth surface 121 and a second metal trace 110, arranged adjacent to the first metal trace 120, comprises a rough surface 111. It is also possible that a metal trace comprises regions with a smooth surface 121 and with a rough surface 122. As has been described for Figures 3 and 4 above, these metal traces 110, 120 can be directly manufactured with the described method. The rough surfaces 111, 122 correspond to second portions, which have been processed, while the first portions had been protected by the protection layer 150. In turn, the smooth surfaces 121 correspond to first portions, which had been protected during surface roughening of the second portions.

**Figure 6** shows steps of removing the protection layer 150 from the component carrier 100 surface according to further exemplary embodiments of the invention.

Figure 6a: in this example, the fluid jet 160 is provided in the vertical direction z in an angle α between an imaginary plane Ia, being parallel to the component carrier surface (along x, y directions), and the fluid jet 160 direction. In this example, the angle α is 60°.

Figure 6b: in this example, additionally or alternatively to Figure 6b, the fluid jet 160 is provided in the horizontal direction (x, y) in an angle β between a further imaginary plane (Ib), being perpendicular to the component carrier surface/imaginary plane (Ia) and oriented along the x and z directions. In this example, the angle β is 45°.

It can be seen in both examples, that more than one fluid jet 160 is provided to the component carrier surface. The arrow on the left side of each example indicates the forwarding (movement) direction of the component carrier preform 100 in a protection layer removal device 200 of a manufacture apparatus. In these examples, the fluid jet 160 directions are applied in an opposed direction with respect to the forwarding direction indicated by the arrow. Thus, while the forwarding direction (machine direction) can be seen as a first flow direction, the fluid jet 160 directions can be seen as second flow directions that are applied counter flow (reverse flow) with respect to the first current direction.

### Reference signs

- 100: Component carrier (preform)
- 110: Second metal trace
- 111: Rough surface
- 120: First metal trace
- 121: Smooth surface
- 122: Alternating rough surface
- 130: First portion
- 140: Second portion
- 150: Protection layer
- 160: Fluid jet (direction)
- 170: High pressure cleaner, fluid nozzle
- 200: Protection layer removal device

## Claims

1. A method of manufacturing a component carrier, the method comprising:
providing a component carrier (100) with at least one electrically insulating layer structure and/or at least one electrically conductive layer structure;
forming a protection layer (150) on the component carrier (100),
so that a first portion (130) of the surface of the component carrier (100) is covered with the protection layer (150), and a second portion (140) of the surface of the component carrier (100) is not covered with the protection layer (150);
performing a component carrier manufacture step with respect to the second portion (140); and afterwards
removing the protection layer (150) from the first portion (130) using a pressurized fluid.

2. The method according to claim 1,
wherein the physical state of the fluid is at least one of liquid, gaseous, supercritical; and/or
wherein the fluid comprises organic and/or inorganic substances and/or dispersed solids.

3. The method according to claim 1 or 2,
wherein the removing is done without using an organic solvent,
in particular done essentially without using additional chemical substances.

4. The method according to any one of the preceding claims,
wherein the pressure of the pressurized fluid is 2 bar or more, in particular 3 bar or more;
and/or
wherein the temperature of the pressurized fluid is 25°C or more, in particular 40°C or more, in particular 60°C or more.

5. The method according to any one of the preceding claims,
wherein the pressurized fluid is applied as a jet (160),
in particular wherein the jet is provided by a high-pressure cleaner (170) or a fluid nozzle.

6. The method according to claim 5,
wherein, during removing, an angle (α) in the vertical (z) direction between an imaginary plane (Ia), being parallel to the component carrier surface, and the fluid jet (160) direction is in the range 40° to 80°, in particular 50° to 70°, more in particular 55° to 65°; and/or
wherein, during removing, an angle (β) in the horizontal (x, y) direction between a further imaginary plane (Ib), being perpendicular to the imaginary plane (Ia), and the fluid jet (160) direction is in the range 30° to 70°, in particular in the range 40° to 50°.

7. The method according to any one of the preceding claims,
wherein at least the micro-structure of the protection layer (150) is not decomposed by the fluid, in particular is not destroyed during the removing.

8. The method according to any one of the preceding claims,
wherein the protection layer (150) is chemically inert,
in particular stable against acidic and alkaline substances;
and/or
wherein the protection layer (150) is heat-resistant,
in particular resistant against soldering temperatures.

9. The method according to any one of the preceding claims,
wherein the protection layer (150) comprise at least one of the group which consists of an elastic polymer coating, an ink, an adhesion promoter, in particular a bond film, a peel-off film, a strip varnish.

10. The method according to any one of the preceding claims,
wherein the protection layer (150) comprise an elastic material,
in particular wherein the Young's modulus of the protection layer is range 0.005 GPa to 0.5 GPa, more in particular in the range 0.01 GPa to 0.1 GPa, more in particular in the range 0.025 GPa to 0.075 GPa.

11. The method according to any one of the preceding claims,
wherein providing the protection layer (150) comprises:
coating, in particular printing, more in particular screen printing, the protection layer (150) on the first portion (130);
and/or
providing a solder resist to the component carrier (100) prior to providing the protection layer (150).

12. The method according to any one of the preceding claims,
wherein the component carrier manufacture step of the second portion (140) comprises at least one of the group which consists of: roughening , in particular by micro-etching, etching, addition of a layer structure, plating, differential etching, bonding, adhesion, oxidation, in particular black oxide treatment, precleaning, providing surface preservative, submerging, assembly of a component, provision of a cavity.

13. A component carrier manufacture apparatus, comprising:
a protection layer removal device (200) comprising at least one, in particular a plurality of, high pressure fluid nozzles (170), more in particular a nozzle array, that are configured to provide a plurality of pressurized fluid jets (160), respectively, and
wherein the protection layer removal device (200) is configured to remove a protection layer (150), using the plurality of pressurized fluid jets (160), from a first portion (130) of surface of a component carrier (100),
wherein the first portion (130) of the surface of the component carrier (100) is covered with the protection layer (150), and a second portion (140) of the surface of the component carrier (100) is not covered with the protection layer (150).

14. The component carrier manufacture apparatus according to claim 13, further comprising at least one of the following features: a loader device, a preheater device, a protection layer removal chamber, a component carrier cleaning device, in particular an ultra-sonification device, a dryer device, an unloader device.

15. Using a pressurized fluid jet (160) to remove a protection layer (150) from a portion (130) of a surface (130) of a component carrier (100) in a residue-free manner.
